# FASCICULE DE BREVET EUROPEEN

(11) **EP 2 245 474 B1**
(45) Date de publication et mention de la délivrance du brevet: **05.12.2012**
(21) Numéro de dépôt: 09723515.4
(22) Date de dépôt: 17.02.2009
(51) Int. Cl.: G01R 31/3185

(54) **DISPOSITIF ET PROCEDE D'OBSERVATION ET D'EXPLOITATION DE SIGNAUX INTERNES D'UN SYSTEME PROGRAMMABLE**
VORRICHTUNG UND VERFAHREN ZUR ÜBERWACHUNG UND VERWENDUNG INTERNER SIGNALE IN EINEM PROGRAMMIERBAREN SYSTEM
DEVICE AND METHOD FOR MONITORING AND USING INTERNAL SIGNALS IN A PROGRAMMABLE SYSTEM

(30) Priorité: 22.02.2008 FR 0851154
(43) Date de publication de la demande: 03.11.2010
(73) Titulaire: Adacsys, 91120 Palaiseau (FR)
(72) Inventeur: HOCHAPFEL, Erik, F-91300 Massy (FR); REMY Pascal, F-75005 Paris (FR)
(74) Mandataire: Novagraaf Technologies
(86) Numéro de dépôt international: PCT/FR2009/000173
(87) Numéro de publication internationale: WO 2009/115680

(56) Documents cités:
- EP-A- 1 233 341
- US-A- 5 764 079
- US-A- 6 157 210
- US-B1- 6 681 353

## Description

La présente invention concerne un dispositif et un procédé d'observation et d'exploitation de signaux internes d'un système programmable.

### DOMAINE TECHNIQUE

La présente invention concerne le domaine des circuits logiques programmables.

Elle concerne plus particulièrement les dispositifs et procédés pour réaliser l'observation et l'exploitation de signaux internes d'un système programmable constitué d'au moins un circuit programmable.

### ÉTAT DE LA TECHNIQUE ANTERIEURE

L'état de la technique comporte des circuits logiques programmables de type PLD (SPLD ou CPLD) et FPGA. Ces circuits permettent d'accéder à une puissance de calcul très importante en raison du traitement intrinsèquement parallèle des instructions qui est mis en oeuvre, comparativement aux architectures d'ordinateurs de type CISC ou RISC pour lesquelles ces traitements sont séquentiels.

Un système programmable est alors conçu comme un ensemble formé par un ou plusieurs circuits logiques programmables, ces circuits pouvant être éventuellement interconnectés.

Afin que l'utilisation et l'exploitation d'un tel système puisse être réalisé de manière optimale, il est nécessaire de pouvoir assurer l'observabilité des signaux internes des circuits programmables composant ce système. L'observabilité des signaux internes consiste à connaître la valeur de ces signaux.

Cette observabilité met en évidence plusieurs problèmes parmi lesquels :
- le faible nombre de connecteurs d'entrée-sortie par rapport à la capacité interne toujours croissante des circuits programmables,
- la disparition d'un nombre non négligeable de données d'une description implémentée dans un ou plusieurs circuits programmables, Ces données ne peuvent par conséquent être observées et donc exploitées puisque n'ayant pas de signaux internes associés.
- le transfert des valeurs des signaux internes d'un circuit programmable, entre un circuit programmable et un ou plusieurs autres circuits programmables et/ou éléments électroniques, et
- le transfert des valeurs des signaux internes d'un ou plusieurs circuits programmables entre circuits programmables, et/ou entre un ou plusieurs circuits programmables et un système électronique « hôte » (ordinateur ou autre) permettant leur exploitation instantanée ou ultérieure.

Parmi ces différents problèmes, le dernier - de transfert des valeurs des signaux internes d'un ou plusieurs circuits programmables entre un ou plusieurs circuits programmables et un système électronique hôte - limite la vitesse à laquelle peut s'effectuer l'observation des valeurs des signaux internes.

Pour résoudre ce problème de transfert des valeurs des signaux internes entre un ou plusieurs circuits programmables et un système hôte, l'état de la technique comprend plusieurs dispositifs et procédés permettant d'obtenir une observabilité partielle des signaux internes des circuits programmables. Ces solutions consistent en la récupération des valeurs des signaux internes sur un système hôte permettant leur exploitation.

Un principe général consiste à récupérer les valeurs des signaux internes sur la station de travail qui pilote les circuits programmables en cours d'utilisation.

L'état de l'art consiste à utiliser une interface spéciale pour récupérer les valeurs des signaux internes. La liaison peut se faire par exemple au moyen d'un port série JTAG ou d'une interface propriétaire à haut débit. Une réalisation de cette solution est décrite dans le brevet US 6,157,210 qui vise un dispositif logique programmable comportant un circuit. Ce circuit peut être utilisé pour l'observation de signaux internes de circuits logiques programmables en vue de la vérification fonctionnelle de circuits spécifiques implémentés sur un circuit programmable. Il peut également être utilisé pour le pré-chargement de circuits logiques programmables. D'autres solutions sont également décrites selon ce principe dans les brevets US 6,286,114 et US 7,078,929.

Le brevet US 6,681,353 concerne un circuit FPGA permettant d'obtenir une trace d'un signal numérique, sans utiliser d'analyseur de logique externe. Le dispositif décrit dans ce document comprend pour cela un circuit de test, configuré pour obtenir une trace d'un signal numérique circulant dans le circuit, en capturant des échantillons de ce signal numérique en réponse à un signal de contrôle puis en stockant les échantillons capturés dans la mémoire du circuit FPGA qui est accessible sans nécessiter d'analyseur de logique.

L'inconvénient de ces solutions de l'état de la technique réside dans la nécessité d'avoir physiquement l'ensemble ou une très grande proportion des valeurs des signaux internes des circuits programmables dans le système hôte afin de pouvoir les exploiter. Ces valeurs sont ainsi stockées soit sur une mémoire volatile, soit sur une unité de stockage - interne ou externe - appartenant au système hôte. Cette nécessité provoque l'apparition d'un goulot d'étranglement au niveau de la liaison entre le système programmable et le système hôte, de même qu'entre les différents circuits programmables du système programmable, et ce d'autant plus que le système comporte un nombre important de circuits programmables. Un système programmable est à ce titre défini comme un système comportant au moins une partie programmable ou reprogrammable contenant un ou plusieurs circuits programmables.

De plus, ces solutions, pour être rapides et optimales, nécessitent une capacité de stockage des valeurs des signaux à observer très nettement supérieure à celle disponible sur le système programmable.

D'autres solutions de l'état de la technique visent à améliorer la communication entre le système programmable et le système hôte dans le but d'accélérer le flot de données par unité de temps entre ces entités.

Dans toutes ces solutions, le rapport entre la quantité de valeurs des signaux internes à observer et exploiter et la capacité du canal, ou des canaux de communication, est tel que cela en fait le facteur limitant de l'ensemble composant le système programmable et le système hôte. Ce facteur limitant correspond à la vitesse de fonctionnement de l'ensemble formé par le système programmable et le système hôte, indépendamment de la vitesse de fonctionnement des différents éléments de cet ensemble, ce qui est d'autant plus significatif en fonctionnement en temps réel.

Ainsi cette limitation empêche d'obtenir une vitesse de fonctionnement de l'ensemble suffisante si les circuits programmables disposent d'un nombre important de signaux internes à observer.

### OBJET DE L'INVENTION

Le but de la présente invention est de remédier à ces problèmes techniques, en permettant l'observabilité des signaux internes des circuits programmables sans subir de goulot d'étranglement au niveau de la communication entre le système programmable et le système hôte. L'invention propose pour cela de ne pas obligatoirement rapatrier tout ou partie des valeurs des signaux internes, non seulement pendant toute la durée de l'exécution, mais également par la suite, lors de l'exploitation même de ces données.

L'approche de la solution a consisté à chercher dans un premier temps une architecture matérielle, à base de circuits programmables, optimisée pour l'exploitation des valeurs des signaux internes à observer des circuits programmables. Cette recherche a abouti à l'ajout à chaque circuit programmable d'une unité physique de stockage de type mémoire volatile, permettant de diminuer le goulot d'étranglement et de conserver localement l'intégralité ou une partie des valeurs des signaux à observer.

La recherche de moyens d'exploitation des valeurs de ces signaux stockés sur les mémoires volatiles a alors conduit à entrevoir la possibilité d'effectuer l'ensemble des traitements nécessaires à l'exploitation de ces signaux, contrairement aux solutions de l'état de la technique, en les laissant sur le système programmable et en établissant les requêtes à partir du système hôte.

L'invention vise ainsi à effectuer l'intégralité ou une partie des traitements nécessaires à l'exploitation des signaux à observer localement, au niveau du système programmable, par l'utilisation d'unités de stockage, chaque unité de stockage étant reliée à un ou plusieurs circuits programmables du système programmable.

Dans ce but, la présente invention propose un dispositif d'observation et d'exploitation de signaux internes d'un système programmable, ledit dispositif étant constitué d'un système programmable comprenant au moins un circuit programmable et d'au moins un système hôte apte à communiquer avec ledit système programmable pour la commande de l'observation et de l'exploitation des signaux internes d'au moins un circuit programmable, caractérisé en ce qu'il comprend également :
- au moins une unité de stockage local, chaque unité de stockage étant reliée via au moins une interface à au moins un circuit programmable,
- au moins une unité de logique de contrôle et d'échange de données entre au moins un système hôte et au moins une interface ainsi qu'au moins un circuit programmable associé à au moins une interface, l'observation et l'exploitation des signaux internes de chaque circuit programmable reliée à au moins une unité de logique de contrôle et d'échange de données étant commandées par un système hôte et réalisées à partir d'au moins une unité de stockage associée, et
- au moins une unité de traitement et de contrôle reliée à au moins un système hôte, chaque unité de traitement comprenant des moyens de communication entre le système hôte associé et au moins une unité de stockage et des moyens d'indexage des signaux internes de chaque circuit programmable associé à au moins une interface par rapport à chaque unité de stockage.

Un tel dispositif permet la complète observation et exploitation par le système hôte des valeurs des signaux internes à observer d'au moins un circuit programmable, ceux-ci étant stockés sur un support interne au système programmable contrôlé par le système programmable et par le système hôte. Ainsi, l'observation et l'exploitation complète des signaux internes directement sur les unités de stockage permet d'économiser le temps de rapatriement de tout ou partie des valeurs des signaux internes à observer sur le système hôte.

Selon des modes de réalisation avantageux :
- au moins une unité de traitement et de contrôle comprend également des moyens de traitement des valeurs des signaux internes d'au moins un circuit programmable,
- les moyens de traitement desdites valeurs des signaux internes réalisent en outre la récupération des plages de valeurs de signaux stockés sur au moins une unité de stockage,
- les moyens de traitement desdites valeurs des signaux internes réalisent en outre au moins une opération sur les valeurs des signaux stockés sur au moins une unité de stockage,
- les moyens de traitement desdites valeurs des signaux internes réalisent en outre la consolidation d'opérations effectuées à partir des valeurs de signaux stockés sur au moins une unité de stockage.

Ces modes de réalisation permettent l'exploitation complète des valeurs des signaux internes entièrement sur les unités de stockage, tout en se faisant aussi rapidement que si elles étaient déjà stockées sur le système hôte.

Dans le cas où le dispositif comprend au moins deux unités de stockage, le traitement desdits signaux internes est avantageusement réalisé en parallèle sur au moins deux unités de stockage. Le dispositif est rendu ainsi apte à réaliser les différents traitements sur les différents circuits programmables de manière encore plus rapide.

Dans le cas où le dispositif comprend au moins deux circuits programmables, au moins deux circuits programmables sont avantageusement reliés via un réseau d'interconnexion. Les circuits programmables peuvent de cette manière communiquer entre eux des données, par exemple pour répartir équitablement la charge de traitement des données à traiter sur chacun d'eux et effectuer des consolidations.

Dans le cas où le dispositif comprend au moins deux interfaces, au moins deux interfaces sont avantageusement reliées via un réseau d'interconnexion. Cette interconnexion permet un échange de données directement entre les unités de stockage, par l'intermédiaire des interfaces.

Selon un mode de réalisation particulier de l'invention, chaque circuit programmable du système programmable est associé via au moins une interface à au moins une unité de stockage. L'ensemble des données de chaque circuit programmable du système peut ainsi être mémorisé sur une unité de stockage, ce qui permet d'observer et d'exploiter l'ensemble des données de tous les circuits.

Selon un autre mode de réalisation particulier, dans le cas où le dispositif comprend au moins deux circuits programmables, au moins deux circuits programmables parmi les au moins deux circuits programmables sont reliés à une même unité de stockage via une même interface. Il est ainsi possible d'avoir un nombre de circuits programmables supérieur au nombre d'unités de stockage, tout en permettant que les données de chaque circuit puissent être observées et exploitées.

Selon un autre mode de réalisation particulier, le système programmable comporte également au moins une processeur équipé d'une unité de logique de contrôle pour la réalisation de tâches spécifiques. Le système dispose ainsi de circuits intégrés aptes à réaliser plusieurs tâches en même temps et à réaliser des tâches spécifiques très rapidement, ce qui améliore encore la vitesse de fonctionnement du dispositif.

Selon un autre mode de réalisation particulier, au moins un circuit programmable comprend au moins un processeur de placement routage. Le dispositif dispose ainsi de moyens de placement routage d'au moins une partie des circuits programmables, de façon à les distribuer sur tout le système et à diminuer le temps de portage, c'est-à-dire l'adaptation d'un programme dans un environnement autre que son environnement d'origine.

Dans un mode de réalisation particulier de l'invention, au moins une partie d'au moins une unité de stockage est utilisée pour le stockage d'au moins un stimulus afin d'exciter au moins un signal parmi les signaux internes des circuits programmables et une entrée d'un processeur. Un stimulus correspond à l'ensemble des valeurs que peut prendre un signal dans le temps. Il permet de stimuler le signal interne du circuit programmable du système programmable auquel il se réfère et dans lequel il se trouve. Chaque stimulus est chargé dans une unité de stockage puis récupéré afin de stimuler le signal interne correspondant du circuit programmable dans lequel il se trouve.

Préférentiellement, au moins une unité de stockage est de type mémoire volatile. Les unités de stockage ainsi constituées sont donc susceptibles de renouveler le contenu des données stockées, et nécessitent des capacités de stockage réduites par rapport à d'autres types de mémoires physiques.

Préférentiellement, au moins une liaison parmi les liaisons entre les éléments constitutifs du dispositif est une liaison rapide de débit supérieur à 1 Gigabit/seconde.

Les échanges de données peuvent ainsi s'effectuer de manière plus rapide entre les éléments concernés, ce qui est plus particulièrement avantageux dans le cas des liaisons entre circuits programmables et unités de stockage.

Selon un mode de réalisation particulier, au moins une liaison parmi les liaisons entre les éléments constitutifs du dispositif est une liaison sans fil. Il n'est ainsi plus nécessaire que les éléments concernés soient suffisamment proches, et de plus l'encombrement par les câbles de liaison est diminué.

L'invention concerne également un procédé d'observation et d'exploitation de signaux internes d'un système programmable, ledit dispositif étant constitué d'un système programmable comprenant au moins un circuit programmable et d'au moins un système hôte apte à communiquer avec ledit système programmable pour la commande de l'observation et de l'exploitation des signaux internes d'au moins un circuit programmable, ledit procédé mettant en oeuvre un tel dispositif d'observation et d'exploitation de signaux internes d'un système programmable.

### BREVE DESCRIPTION DES DESSINS

L'invention sera mieux comprise à la lecture de la description détaillée d'un exemple non limitatif de réalisation, accompagnée de figures représentant respectivement :
- la figure 1, un dispositif d'observation et d'exploitation des signaux d'un système programmable conforme à un premier mode de réalisation de l'invention,
- la figure 2, un procédé de conception d'un algorithme sur un système programmable, en vue de l'accélération de celui-ci, conformément à un mode de réalisation de l'invention,
- la figure 3, un dispositif conforme à un deuxième mode de réalisation de l'invention,
- la figure 4, un dispositif conforme à un troisième mode de réalisation de l'invention,
- la figure 5, un dispositif conforme à un quatrième mode de réalisation de l'invention,
- la figure 6, un dispositif conforme à un cinquième mode de réalisation de l'invention,
- la figure 7, un dispositif conforme à un sixième mode de réalisation de l'invention,
- la figure 8, un dispositif conforme à un septième mode de réalisation de l'invention, et
- la figure 9, un dispositif conforme à un huitième mode de réalisation de l'invention.

### EXPOSE DETAILLE DE MODES DE REALISATION PARTICULIERS

Dans ce qui suit, un système programmable sera défini comme un système comportant au moins une partie programmable ou reprogrammable contenant un ou plusieurs circuits programmables. Un circuit programmable sera défini ici comme un circuit intégré logique programmable qui peut être reprogrammable ou non après sa fabrication. De plus, on entendra dans ce qui suit par observation (respectivement exploitation) des signaux internes l'observation (respectivement l'exploitation) à un instant donné des valeurs de ces signaux.

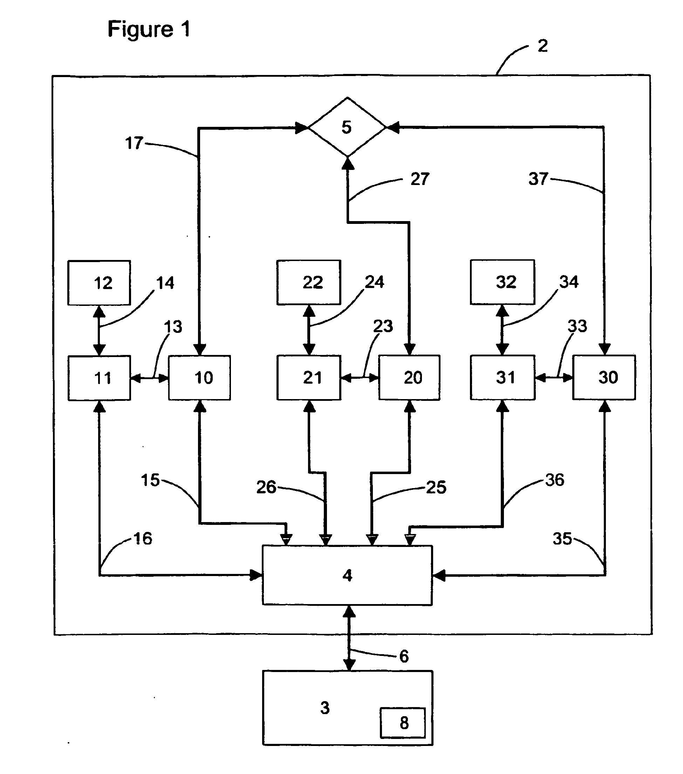

La figure 1 représente un dispositif d'observation et d'exploitation des signaux d'un système programmable conforme à un premier mode de réalisation de la présente invention.

Ce dispositif comprend un système programmable 2 et un système hôte 3. Le système hôte 3 est un système électronique apte à communiquer avec le système programmable 2. Il est relié à une unité de traitement et de contrôle 8, qui peut être par exemple un ordinateur. Cette unité 8 peut être déportée ou disposée à l'intérieur dudit système hôte 3.

Le système programmable 2 comprend trois circuits logiques programmables 10,20,30. Il est entendu que l'invention peut être réalisée avec un nombre différent de circuits programmables. Ces circuits programmables peuvent être par exemple des circuits FPGA (réseau de portes programmables in-situ, soit en langue anglo-saxonne « field-programmable gâte array ») ou PLD (circuit logique programmable, soit en langue anglo-saxonne « programmable iogic device »), ces derniers pouvant être simples (SPLD) ou complexes (CPLD).

Chaque circuit programmable 10,20,30 comporte une pluralité de signaux internes que le dispositif selon l'invention vise à observer et exploiter.

Préférentiellement, ces circuits programmables 10,20,30 sont reliés les uns aux autres par un réseau d'interconnexion 5, via respectivement les liaisons 17,27,37. Ce réseau 5 peut contenir de la logique, comme par exemple de la logique de contrôle et d'aiguillage.

Chaque circuit programmable 10,20,30 est associé respectivement à une unité de stockage local d'information 12,22,32 via une interface 11,21,31. Chaque unité de stockage d'information 12,22,32 permet le stockage des valeurs des signaux internes au circuit programmable 10,20,30 associé. Elle est reliée à chaque interface 11,21,31 via une liaison 14,24,34.

Chaque interface 11,21,31 permet de relier un circuit programmable 10,20,30 à une unité de stockage d'information 12,22,32. Ces interfaces peuvent être de différentes natures, par exemple de nature logique, physique, IP ou autre. Elle est reliée à chaque unité de stockage 12,22,32 via une liaison 14,24,34 et à chaque circuit programmable 10,20,30 via une liaison 13,23,33.

Le système programmable 2 comprend également une unité de logique de contrôle et d'échange de données 4. Cette unité de logique 4 est reliée à chaque circuit programmable 10,20,30 via une liaison 15,25,35, ainsi qu'à chaque interface 11,21,31 via une liaison 16,26,36. Cette unité de logique 4 peut ainsi accéder aux circuits programmables ainsi qu'aux valeurs des signaux internes de ces circuits programmables par l'intermédiaire des interfaces.

Le système hôte 3 communique avec le système programmable 2 par l'intermédiaire de l'unité de logique 4. Cette communication est établie via la liaison 6, qui réalise l'échange des données entre les deux systèmes 2,3.

L'unité de traitement et de contrôle 8 permet de réaliser l'observation et l'exploitation des signaux d'au moins un circuit programmable 10,20,30, choisi par l'utilisateur du système hôte 3. Cette unité de traitement et de contrôle comporte à cet effet plusieurs moyens, parmi lesquels :
- des moyens d'instrumentation du circuit programmable en vue de communiquer avec chaque unité de stockage 12,22,32 associé à chaque circuit 10,20,30 à observer,
- des moyens d'indexage, couplé aux dits moyens d'instrumentation, de tous les signaux internes à observer,
- des moyens de traitement des valeurs de ces signaux, permettant la réalisation d'opérations distribuées sur l'ensemble des unités de stockage 12,22,32 associées.

Le traitement de ces signaux par lesdits moyens de traitement dépend de l'application visée par le dispositif. Il peut réaliser en outre plusieurs traitements parmi les suivants :
- la récupération de plages de valeurs de signaux stockées sur une ou plusieurs unités de stockage 12,22,32 associées,
- des opérations sur les valeurs de signaux stockées sur une ou plusieurs unités de stockage 12,22,32 associées, et
- la consolidation d'opérations effectuées à partir des valeurs de signaux stockées sur une ou plusieurs unités de stockage 12,22,32 associées.

Par l'intermédiaire de l'unité de logique 4, de chaque interface 11,21,31 et de chaque unité de stockage 12,22,32, le système hôte 3 est ainsi apte à commander l'observation et l'exploitation des signaux internes des circuits programmables 10,20,30 sans avoir à charger au préalable l'intégralité de ces valeurs sur ce système. L'observation et l'exploitation se réalise en effet directement sur chaque unité de stockage 12,22,32 et non pas à partir du système hôte 3.

A cet effet, la création d'un index, ou d'une table de hashage, par le programme d'observation et d'exploitation des signaux internes du système programmable 2, permet de savoir dans quelle unité de stockage 12,22,32 trouver la valeur de tout signal à observer, interne à un circuit programmable 10,20,30, afin d'exploiter cette valeur directement sur l'unité de stockage associé à ce circuit programmable.

De plus, la technique utilisée pour le stockage des données dans les unités de stockage 12,22,32 est choisie de sorte à être proche de celles des entités qui les hébergent et éventuellement les manipulent. Cela permet d'exploiter en parallèle et localement ces données et ce, beaucoup plus rapidement que si elles étaient stockées sur le système hôte 3.

Après les traitements effectués par l'unité de traitement et de contrôle 8 et commandés par le système hôte 3, comme par exemple des opérations sur les valeurs des signaux à observer, ce système hôte sera apte à requérir le rapatriement des valeurs des résultats consolidés directement sur le système hôte. Ainsi la liaison 6 entre le système hôte et le système programmable 2 ne réalise que l'échange de données sélectionnées par le système hôte, ces données ayant déjà fait l'objet d'un traitement sur les unités de stockage 12,22,32. La liaison 6 est par conséquent rendue moins encombrée que si le système hôte rapatriait toutes les données pour les traiter à son niveau, et la vitesse de fonctionnement du dispositif est rendue d'autant plus importante.

Un tel dispositif peut être utilisé pour diverses applications parmi lesquelles l'accélération d'algorithmes, la vérification fonctionnelle des circuits intégrés, ainsi que le calcul haute performance. L'accélération d'algorithmes peut être utilisée dans différents domaines, comme par exemple la mécanique des fluides, la sismographie, la bioinformatique, ou pour des problématiques d'optimisation de graphes et d'hypergraphes, en particulier pour les voyageurs de commerce, des plannings ou des ressources. La vérification fonctionnelle peut concerner les circuits intégrés, les systèmes sur puce, les circuits programmables (PLD ou FPGA) ou les algorithmes.

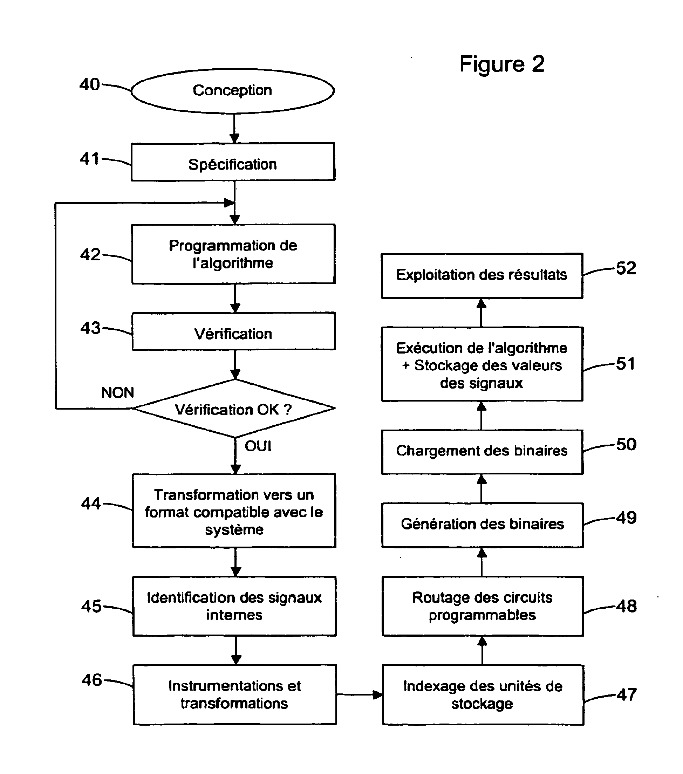

La figure 2 représente un procédé de conception d'un algorithme sur un système programmable, en vue de l'accélération de celui-ci, conformément à un mode de réalisation de la présente invention.

Ce procédé de conception 40 vise à réaliser un algorithme sur un système programmable, en vue de son accélération par rapport à un ordinateur de type RISC ou CISC. Le dispositif d'observation et d'exploitation utilisé est identique à celui décrit précédemment et illustré par la figure 1. Le système hôte est ici un ordinateur de type RISC ou CISC, qui permet de lancer des requêtes en direction du système programmable. Les circuits programmables sont de type FPGA.

Après une première phase d'écriture des spécifications fonctionnelles 41 de l'algorithme, la phase de programmation 42 de l'application peut commencer. Cet algorithme est écrit dans un langage de programmation, par exemple le langage C/C++. Dans d'autres modes de réalisation, il peut être réalisé par exemple en langage HDL ou Fortran.

Suite à cette étape de programmation, on procède à la vérification 43 du fonctionnement de l'algorithme sur un jeu de test réduit en le compilant sur une architecture RISC ou CISC. Si le résultat de la vérification n'est pas conforme, la phase de programmation 42 est répétée, puis celle de vérification 43, jusqu'à l'obtention d'un résultat conforme.

Un logiciel permettant la traduction de l'algorithme en langage C vers le langage HDL et permettant ainsi son implémentation dans un circuit FPGA réalise la transformation 44 de l'algorithme vers un format compatible avec le système programmable cible. A cet effet, ce logiciel transforme le langage C en un langage HDL compatible avec les circuits programmables utilisés par le système programmable cible. Il est exécuté sur l'ensemble des fichiers constituant la programmation 42 de l'algorithme.

L'utilisateur peut ensuite procéder à la déclaration 45 d'une série de variables qu'il souhaite exploiter à la fin de la vérification. Chaque variable codée sur plus d'un bit correspond à des agrégats de signaux internes aux circuits programmables.

La déclaration 45 donne lieu à une instrumentation qui est effectuée par un des logiciels ou une fonction logicielle de la phase d'instrumentations et de transformations 46. Cette phase d'instrumentations et de transformations 46 est effectuée par un ensemble de logiciels ou de fonctions logicielles permet d'obtenir une description de l'algorithme compatible avec l'architecture matérielle du système programmable 2 composé des circuits programmables.

Cette phase d'instrumentations et de transformations 46 comprend :
- instrumentation pour l'observation des signaux déclarés en 45
- une étape de partitionnement, qui permet de distribuer l'algorithme transformé sur l'ensemble des circuits programmables du système programmable cible 2,
- une étape d'ajout de blocs permettant la future exploitation des signaux internes que l'utilisateur souhaite observer et exploiter, et

- une étape d'initialisation des mémoires du système programmable cible.

Cette phase d'instrumentation et de transformations 46 peut être complétée par d'autres étapes supplémentaires à celles décrites ci-dessus en vue d'améliorer la performance de l'algorithme.

Une phase d'indexage 47 permet ensuite de connaître sur quelle ressource physique de mémoire se trouvent les signaux internes précédemment identifiés comme étant à exploiter. Il est pour cela construit un index associant à chaque signal identifié l'unité de stockage sur laquelle elle est en mémoire. Cet indexage est suivi d'une phase de placement routage 48 pour chaque circuit programmable. Puis pour chaque circuit programmable, des binaires de programmation sont générés sous le forme d'un fichier binaire de programmation par circuit programmable, lors de la phase de génération 49. Ces fichiers binaires obtenus précédemment sont ensuite chargées dans chaque circuit programmable lors de la phase de chargement 50.

L'utilisateur peut dès lors procéder à l'exécution 51 de l'algorithme sur le système programmable. Cette phase d'exécution est couplée au stockage des valeurs des signaux internes à exploiter de chaque circuit programmable sur chaque unité de stockage associé au circuit programmable correspondant. A la fin de l'exécution 51 de l'algorithme sur le système programmable, l'intégralité des valeurs des signaux à exploiter se trouvent ainsi sur les unités de stockage.

Enfin, à la fin de cette phase 51, l'utilisateur peut procéder à l'exploitation 52 des résultats de l'exécution de l'algorithme sur le système programmable. Cette exploitation est réalisée au moyen d'un envoi de requêtes au système programmable par l'utilisateur, par l'intermédiaire de la connexion 6 entre le système hôte 3 et le système programmable 2.

Ces requêtes peuvent par exemple consister en la visualisation dans une fenêtre d'un ensemble de signaux, les valeurs étant chargées à la demande, ou la comparaison de signaux avec une référence, cette comparaison pouvant se faire soit sur l'ordinateur, soit directement sur le système programmable si la référence a été préalablement chargée sur ce dernier.

Un tel procédé de conception d'algorithme à partir d'un système programmable, associé à un tel dispositif d'observation et d'exploitation de signaux internes de ce système programmable, permet d'obtenir un traitement de l'algorithme plus rapide que dans le cas où celui-ci est traité par un ordinateur de type CISC ou RISC.

D'autres variantes de réalisation d'un dispositif selon la présente invention peuvent être mises en oeuvre comme décrit ci-après.

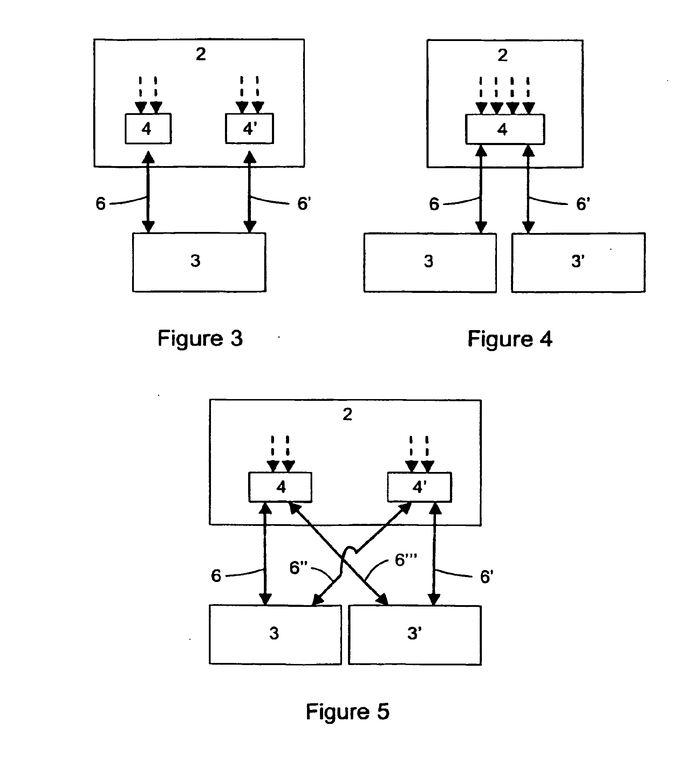

Selon le mode de réalisation illustré par la figure 3, le système programmable 2 comprend deux unités de logique de contrôle et d'échange de données 4,4'. Chaque unité de logique 4,4' est reliée au système hôte 3 par une liaison 6,6'. Chacune des deux unités de logique 4,4' est également reliée à une pluralité de circuits programmables, chaque circuit programmable n'étant relié qu'à l'une des deux unités de logique 4,4'. Chaque unité de logique de contrôle et les circuits programmables qui sont reliés à elle constituent ainsi un sous-ensemble programmable. Un tel dispositif permet ainsi de réaliser un système programmable multi-cartes, constitué par une pluralité de sous-systèmes programmables, ce système étant de plus forte capacité et présentant des fonctionnalités potentiellement accrues, puisque présentant plus de logiques et de circuits.

Cette variante peut également être réalisée avec un système programmable constitué d'un nombre d'unités de logique 4,4' - et donc de sous-systèmes programmables - supérieur à deux.

Selon le mode de réalisation illustré par la figure 4, le dispositif d'observation et d'exploitation est constitué de deux systèmes hôtes 3,3'. Chaque système hôte est relié au système programmable 2 par une liaison 6,6'. Un tel dispositif permet de donner l'accès des données à plusieurs systèmes hôte, ceux-ci pouvant envoyer des requêtes d'observation et d'exploitation le système programmable indépendamment les uns des autres. Cette variante peut également être réalisée avec un nombre de système hôte supérieur à deux.

Selon le mode de réalisation illustré par la figure 5, le système programmable 2 est constitué de deux unités de logique 4,4' et de deux systèmes hôtes 3,3'. Chacune des unités de logique de contrôle 4,4' est reliée à chacun des systèmes hôte 3,3' par une liaison 6,6',6",6"'. Cette variante permet de combiner les avantages fournis par les deux précédentes variantes illustrées par les figures 3 et 4. Elle peut également être réalisée avec un nombre de sous-systèmes programmables et de systèmes hôte supérieur à deux.

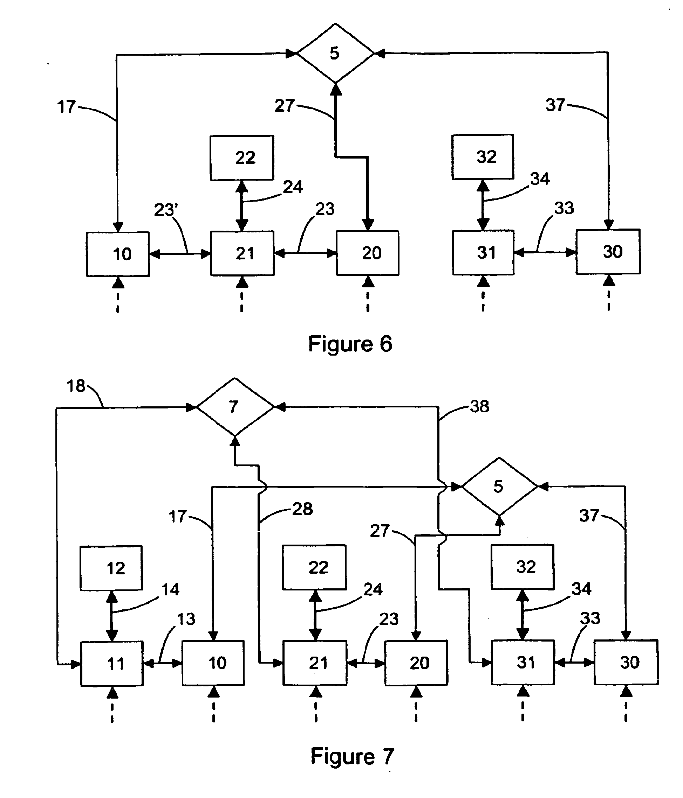

Selon le mode de réalisation illustré par la figure 6, les circuits programmables 10 et 20 sont associés à la même unité de stockage 22 via l'interface 21. L'unité de stockage 22 est ainsi interconnectée avec les deux circuits programmables 10 et 20. Un tel dispositif permet alors de diminuer le nombre d'unités de stockage sans limiter la vitesse de fonctionnement du dispositif, ce nombre d'unités de stockage 22,32 pouvant être rendu inférieur au nombre de circuits programmables 10,20,30, tandis que tous les circuits programmables 10,20,30 sont connectés à au moins une unité de stockage 22,32. Ceci nécessite néanmoins que l'unité de stockage 22 ait une mémoire physique suffisante pour accueillir les données provenant des deux circuits 10,20.

Cette variante peut également être réalisée avec une unité de stockage reliée à plus de deux circuits programmables, si la mémoire physique de cette unité le permet. Ce type de variante peut également être réalisé en reliant un circuit programmable à plusieurs unités de stockage, ou en reliant plusieurs circuits programmables à plusieurs unités de stockage, les nombres de circuits programmables et d'unités de stockage étant différents.

Selon le mode de réalisation illustré par la figure 7, les interfaces 11,21,31 sont interconnectées via un réseau d'interconnexion 7, par l'intermédiaire de liaisons 18,28,38. Cette interconnexion permet aux interfaces de communiquer entre elles et par conséquent d'effectuer des échanges de données entre les unités de stockage de manière directe.

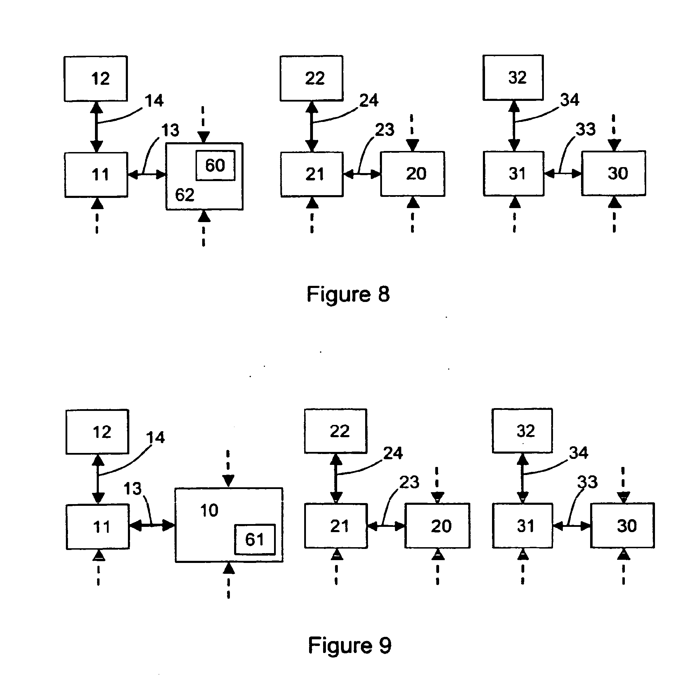

Selon le mode de réalisation illustré par la figure 8, le circuit programmable 10 a été remplacé par un processeur 60 équipé d'une logique de contrôle 62. Ce processeur peut être par exemple de type CPU (unité centrale de traitement, soit en langue anglo-saxonne « central processing unit ») ou GPU (unité de traitement graphique, soit en langue anglo-saxonne « graphics processing unit ») ou de type « cell processor ». Plus généralement, il peut s'agir d'un processeur spécifique et dédié à une ou plusieurs tâches. Cette variante peut également être réalisée en remplaçant plusieurs circuits programmables par plusieurs processeurs, et plus particulièrement en remplaçant chaque circuit programmable par un processeur.

Selon le mode de réalisation illustré par la figure 9, le processeur 61 est compris dans le circuit programmable 10. Cette variante peut être également réalisée en ajoutant plusieurs processeurs à un même circuit programmable. Elle peut aussi être réalisée en ajoutant un processeur à plusieurs circuits programmables, et plus particulièrement en ajoutant un coeur de processeur logiciel ou matériel à chaque circuit programmable. Cette dernière variante offre la possibilité d'effectuer un placement routage des circuits programmables de façon distribuée sur tout le système, et donc de diminuer fortement le temps de portage. Elle permet également de distribuer tous les calculs afférents à l'exploitation des valeurs des signaux internes.

Dans un mode de réalisation particulier de l'invention, au moins une partie d'au moins une unité de stockage 12,22,32 est utilisée pour le stockage d'au moins un stimulus afin d'exciter un signal parmi les signaux internes des circuits programmables 10,20,30 et/ou une entrée d'un processeur 60,61. Un stimulus correspond à l'ensemble des valeurs que peut prendre un signal dans le temps. Il permet de stimuler le signal interne du circuit programmable 10,20,30 du système programmable 2 auquel il se réfère et dans lequel il se trouve. Chaque stimulus est chargé dans une unité de stockage 12,22,32 puis récupéré afin de stimuler le signal interne correspondant du circuit programmable 10,20,30 dans lequel il se trouve.

Dans chacun des modes de réalisation de l'invention précédemment décrits, les liaisons entre les différents éléments constitutifs du dispositif peuvent être des câbles de liaison ou des liaisons sans fil (par exemple « Wifi »). Ces câbles sont préférentiellement à faible bruit et haut débit, comme par exemple des câbles T10 ou T100, de débit au moins supérieur à 1 Gigabit/seconde, des connexions de type LVDS, des fibres optiques.

Une variante peut également consister à utiliser plusieurs types de liaisons différentes dans le même dispositif, en fonction des besoins en termes de quantités de données à échanger entre les éléments.

Les dispositifs selon l'un quelconque de ces modes de réalisation peut également s'appliquer à un système non nécessairement entièrement reprogrammable. En effet, il est possible d'appliquer selon l'un quelconque de ces modes de réalisation à un système spécialisé non reprogrammable, ou reprogrammable en partie et contenant un ou plusieurs circuits non reprogrammable ou non programmable.

Les modes de réalisation précédemment décrits de la présente invention sont donnés à titre d'exemples et ne sont nullement limitatifs. Il est entendu que l'homme du métier est à même de réaliser différentes variantes de l'invention sans pour autant sortir du cadre du brevet.

## Revendications

1. Dispositif d'observation et d'exploitation de signaux internes d'un système programmable (2), ledit dispositif étant constitué d'un système programmable (2) comprenant au moins un circuit programmable (10,20,30) et d'au moins un système hôte (3) apte à communiquer avec ledit système programmable (2) pour la commande de l'observation et de l'exploitation des signaux internes d'au moins un circuit programmable (10,20,30), **caractérisé en ce qu'**il comprend également:
- au moins une unité de stockage local (12,22,32), chaque unité de stockage (12,22,32) étant reliée via au moins une interface (11,21,31) à au moins un circuit programmable (10,20,30),
- au moins une unité de logique de contrôle et d'échange de données (4) entre au moins un système hôte (3) et au moins une interface (11,21,31) ainsi qu'au moins un circuit programmable (10,20,30) associé à au moins une interface (11,21,31), l'observation et l'exploitation des signaux internes de chaque circuit programmable (10,20,30) reliée à au moins une unité de logique de contrôle et d'échange de données (4) étant commandées par un système hôte (3) et réalisées à partir d'au moins une unité de stockage (12,22,32) associée, et
- au moins une unité de traitement et de contrôle (8) reliée à au moins un système hôte (3), chaque unité de traitement et de contrôle (8) comprenant des moyens de communication entre !e système hôte (3) associé et au moins une unité de stockage (12,22,32) et des moyens d'indexage des signaux internes de chaque circuit programmable (10,20,30) associé à au moins une interface (11,21,31) par rapport à chaque unité de stockage (12,22,32).

2. Dispositif d'observation et d'exploitation selon la revendication 1, **caractérisé en ce qu'**au moins une unité de traitement et de contrôle (8) comprend également des moyens de traitement des valeurs des signaux internes d'au moins un circuit programmable (10,20,30).

3. Dispositif d'observation et d'exploitation selon la revendication 2, **caractérisé en ce que** les moyens de traitement desdites valeurs des signaux internes réalisent en outre la récupération des plages de valeurs de signaux stockés sur au moins une unité de stockage (12,22,32).

4. Dispositif d'observation et d'exploitation selon l'une quelconque des revendications 2 à 3, **caractérisé en ce que** les moyens de traitement desdites valeurs des signaux internes réalisent en outre au moins une opération sur les valeurs des signaux stockés sur au moins une unité de stockage (12,22,32).

5. Dispositif d'observation et d'exploitation selon l'une quelconque des revendications 2 à 4, **caractérisé en ce que** les moyens de traitement desdites valeurs des signaux internes réalisent en outre la consolidation d'opérations effectuées à partir des valeurs de signaux stockés sur au moins une unité de stockage (12,22,32).

6. Dispositif d'observation et d'exploitation selon l'une quelconque des revendications précédentes, comprenant au moins deux unités de stockage (12,22,32), **caractérisé en ce que** le traitement desdits signaux internes est réalisé en parallèle sur au moins deux unités de stockage (12,22,32).

7. Dispositif d'observation et d'exploitation selon l'une quelconque des revendications précédentes, comprenant au moins deux circuits programmables (10,20,30), **caractérisé en ce qu'**au moins deux circuits programmables (10,20,30) sont reliés via un réseau d'interconnexion (5).

8. Dispositif d'observation et d'exploitation selon l'une quelconque des revendications précédentes, comprenant au moins deux interfaces (11,21,31), **caractérisé en ce qu'**au moins deux interfaces (11,21,31) sont reliées via un réseau d'interconnexion (7).

9. Dispositif d'observation et d'exploitation selon l'une quelconque des revendications précédentes, **caractérisé en ce que** chaque circuit programmable (10,20,30) du système programmable (2) est associé via au moins une interface (11,21,31) à au moins une unité de stockage (12,22,32).

10. Dispositif d'observation et d'exploitation selon l'une quelconque des revendications précédentes, comprenant au moins deux circuits programmables (10,20,30), **caractérisé en ce qu'**au moins deux circuits programmables (10,20) parmi les au moins deux circuits programmables (10,20,30) sont reliés à une même unité de stockage (22) via une même interface (21).

11. Dispositif d'observation et d'exploitation selon l'une quelconque des revendications précédentes, **caractérisé en ce que** le système programmable (2) comporte également au moins un processeur (60) équipé d'une unité de logique de contrôle (62) pour la réalisation de tâches spécifiques.

12. Dispositif d'observation et d'exploitation selon l'une quelconque des revendications précédentes, **caractérisé en ce qu'**au moins un circuit programmable (10) comprend au moins un processeur (61) de placement routage.

13. Dispositif d'observation et d'exploitation selon l'une quelconque des revendications précédentes, **caractérisé en ce qu'**au moins une partie d'au moins une unité de stockage (12,22,32) est utilisée pour le stockage d'au moins un stimuli afin d'exciter au moins un circuit parmi un circuit programmable (10,20,30) et un processeur (60,61).

14. Dispositif d'observation et d'exploitation selon l'une quelconque des revendications précédentes, **caractérisé en ce qu'**au moins une unité de stockage (12,22,32) est de type mémoire volatile.

15. Dispositif d'observation et d'exploitation selon l'une quelconque des revendications précédentes, **caractérisé en ce qu'**au moins une liaison parmi les liaisons (6,6',6",6"',13,14,15,16,17,18,23,24,25,26,27,28,33,34,35,36,37,38) entre les éléments constitutifs du dispositif est une liaison rapide de débit supérieur à 1 Gigabit/seconde.

16. Dispositif d'observation et d'exploitation selon l'une quelconque des revendications précédentes, **caractérisé en ce qu'**au moins une liaison parmi les liaisons (6,6',6",6"',13,14,15,16,17,18,23,24,25,26;27,28,33,34,35,36,37,38) entre les éléments constitutifs du dispositif est une liaison sans fil.

17. Procédé d'observation et d'exploitation de signaux internes d'un système programmable (2), ledit procédé mettant en oeuvre un dispositif d'observation et d'exploitation de signaux internes d'un système programmable (2) selon l'une quelconque des revendications précédentes, ledit dispositif étant constitué d'un système programmable (2) comprenant au moins un circuit programmable (10,20,30) et d'au moins un système hôte (3) apte à communiquer avec ledit système programmable (2) pour la commande de l'observation et de l'exploitation des signaux internes d'au moins un circuit programmable (10,20,30).

## Claims

1. A device for observing and using internal signals of a programmable system (2), said device consisting of a programmable system (2) including at least one programmable circuit (10, 20, 30) and at least one host system (3) capable of communicating with said programmable system (2) for controlling the observation and use of the internal signals of at least one programmable circuit (10, 20, 30), **characterised in that** it likewise includes:
- at least one local storage unit (12, 22, 32), each storage unit (12, 22, 32) being connected via at least one interface (11, 21, 31) to at least one programmable circuit (10, 20, 30),
- at least one logic unit for controlling and exchanging data (4) between at least one host system (3) and at least one interface (11, 21, 31) as well as at least one programmable circuit (10, 20, 30) associated with at least one interface (11, 21, 31), the observation and use of the internal signals of each programmable circuit (10, 20, 30) connected to at least one logic unit for controlling and exchanging data (4) being controlled by a host system (3) and carried out from at least one associated storage unit (12, 22, 32), and
- at least one processing and control unit (8) connected to at least one host system (3), each processing and control unit (8) including means of communication between the associated host system (3) and at least one storage unit (12, 22, 32) and means of indexing the internal signals of each programmable circuit (10, 20, 30) associated with at least one interface (11, 21, 31) with each storage unit (12, 22, 32).

2. The observation and use device according to claim 1, **characterised in that** at least one processing and control unit (8) likewise includes means of processing the values of the internal signals of at least one programmable circuit (10, 20, 30).

3. The observation and use device according to claim 2, **characterised in that** the means of processing said values of the internal signals further recover the ranges of values of signals stored on at least one storage unit (12, 22, 32).

4. The observation and use device according to any of claims 2 to 3, **characterised in that** the means of processing said values of the internal signals further carry out at least one operation on the values of the signals stored on at least one storage unit (12, 22, 32).

5. The observation and use device according to any of claims 2 to 4, **characterised in that** the means of processing said values of the internal signals further consolidate operations carried out using the values of signals stored on at least one storage unit (12, 22, 32).

6. The observation and use device according to any of the preceding claims, including at least two storage units (12, 22, 32), **characterised in that** the processing of said internal signals is carried out in parallel on at least two storage units (12, 22, 32).

7. The observation and use device according to any of the preceding claims, including at least two programmable circuits (10, 20, 30), **characterised in that** at least two programmable circuits (10, 20, 30) are connected via an interconnection network (5).

8. The observation and use device according to any of the preceding claims, including at least two interfaces (11, 21, 31), **characterised in that** at least two interfaces (11, 21, 31) are connected via an interconnection network (7).

9. The observation and use device according to any of the preceding claims, **characterised in that** each programmable circuit (10, 20, 30) of the programmable system (2) is associated with at least one storage unit (12, 22, 32) via at least one interface (11, 21, 31).

10. The observation and use device according to any of the preceding claims, including at least two programmable circuits (10, 20, 30), **characterised in that** at least two programmable circuits (10, 20) amongst the at least two programmable circuits (10, 20, 30) are connected to a single storage unit (22) via a single interface (21).

11. The observation and use device according to any of the preceding claims, **characterised in that** the programmable system (2) likewise comprises at least one processor (60) provided with a logic control unit (62) for performing specific tasks.

12. The observation and use device according to any of the preceding claims, **characterised in that** at least one programmable circuit (10) includes at least one placement and routing processor (61).

13. The observation and use device according to any of the preceding claims, **characterised in that** at least a portion of at least one storage unit (12, 22, 32) is used for storing at least one stimulus in order to excite at least one circuit from amongst a programmable circuit (10, 20, 30) and a processor (60, 61).

14. The observation and use device according to any of the preceding claims, **characterised in that** at least one storage unit (12, 22, 32) is of the volatile memory type.

15. The observation and use device according to any of the preceding claims, **characterised in that** at least one connection amongst the connections (6, 6', 6", 6''', 13, 14, 15, 16, 17, 18, 23, 24, 25, 26, 27, 28, 33, 34, 35, 36, 37, 38) between the constituent elements of the device is a fast connection with a rate greater than 1 gigabit/second.

16. The observation and use device according to any of the preceding claims, **characterised in that** at least one connection amongst the connections (6, 6', 6'', 6''', 13, 14, 15, 16, 17, 18, 23, 24, 25, 26, 27, 28, 33, 34, 35, 36, 37, 38) between the constituent elements of the device is a wireless connection.

17. A method of observing and using internal signals of a programmable system (2), said method implementing a device for observing and using internal signals in a programmable system (2) according to any one of the preceding claims, said device consisting of a programmable system (2) including at least one programmable circuit (10, 20, 30) and at least one host system (3) capable of communicating with the said programmable system (2) for controlling the observation and use of the internal signals of at least one programmable circuit (10, 20, 30).

## Patentansprüche

1. Vorrichtung zur Beobachtung und Auswertung von internen Signalen eines programmierbaren Systems (2), wobei die Vorrichtung gebildet wird aus einem programmierbaren System (2) mit wenigstens einer programmierbaren Schaltung (10, 20, 30) und wenigstens einem Host-System (3), das so ausgebildet ist, dass dieses mit dem programmierbaren System (2) für die Steuerung der Beobachtung und der Auswertung der internen Signale der wenigstens einen programmierbaren Schaltung (10, 20, 30) kommuniziert, **dadurch gekennzeichnet, dass** diese auch umfasst:
- wenigstens eine lokale Speichereinheit (12, 22, 32), wobei jede Speichereinheit (12, 22, 32) über wenigstens eine Schnittstelle (11, 21, 31) mit wenigstens einer programmierbaren Schaltung (10, 20, 30) verbunden ist,
- wenigstens eine Logikeinheit zur für die Steuerung und den Austausch von Daten (4) zwischen wenigstens einem Host-System (3) und wenigstens einer Schnittstelle (11, 21, 31) sowie wenigstens eine programmierbaren Schaltung (10, 20, 30), die wenigstens einer Schnittstelle (11, 21, 31) zugeordnet ist, wobei die Beobachtung und Auswertung der internen Signale jeder programmierbaren Schaltung (10, 20, 30), die mit wenigstens einer Logikeinheit zur Steuerung und zum Austausch von Daten (4) verbunden ist, durch ein Host-System (3) gesteuert wird und aus wenigstens einer zugeordneten Speichereinheit (12, 22, 32) realisiert wird, und
- wenigstens eine Behandlungs- und Steuereinheit (8), die mit wenigstens einem Host-System (3) verbunden ist, wobei jede Behandlungs- und Steuereinheit (8) eine Kommunikationseinrichtung zwischen dem zugeordneten Host-System (3) und wenigstens einer Speichereinheit (12, 22, 32) und eine Indizierungseinrichtung für die internen Signale jeder programmierbaren Schaltung (10, 20, 30) umfasst, die mit wenigstens einer Schnittstelle (11, 21, 31) in Bezug zu jeder Speichereinheit (12, 22, 32) zugeordnet ist.

2. Vorrichtung zur Beobachtung und Auswertung nach Anspruch 1, **dadurch gekennzeichnet, dass** wenigstens eine Behandlungs- und Steuereinheit (8) auch eine Behandlungseinrichtung für Werte der internen Signale wenigstens einer programmierbaren Schaltung (10, 20, 30) umfasst.

3. Vorrichtung zur Beobachtung und Auswertung nach Anspruch 2, **dadurch gekennzeichnet, dass** die Behandlungseinrichtung für die Werte der internen Signale ferner die Wiedergewinnung von Signalwertebereichen realisiert, die in wenigstens einer Speichereinheit (12, 22, 32) gespeichert sind.

4. Vorrichtung zur Beobachtung und Auswertung nach einem der Ansprüche 2 bis 3, **dadurch gekennzeichnet, dass** die Behandlungseinrichtung die Werte der internen Signale ferner wenigstens eine Operation an den in wenigstens einer Speichereinheit (12, 22, 32) gespeicherten Signalwerten durchführt.

5. Vorrichtung zur Beobachtung und Auswertung nach einem der Ansprüche 2 bis 4, **dadurch gekennzeichnet, dass** die Behandlungseinrichtung der für die Werte der internen Signale ferner die Konsolidierung von Operationen durchführt, die ausgehend in wenigstens einer Speichereinheit (12, 22, 32) gespeicherten Signalwerten durchgeführt werden.

6. Vorrichtung zur Beobachtung und Auswertung nach einem der vorhergehenden Ansprüche, mit wenigstens zwei Speichereinheiten (12, 22, 32), **dadurch gekennzeichnet, dass** die Behandlung der internen Signale parallel in wenigstens zwei Speichereinheiten (12, 22, 32) durchgeführt wird.

7. Vorrichtung zur Beobachtung und Auswertung nach einem der vorhergehenden Ansprüche, mit wenigstens zwei programmierbaren Schaltungen (10, 20, 30), **dadurch gekennzeichnet, dass** wenigstens zwei programmierbare Schaltungen (10, 20, 30) über ein Verbindungsnetz (5) verbunden sind.

8. Vorrichtung zur Beobachtung und Auswertung nach einem der vorhergehenden Ansprüche, mit wenigstens zwei Schnittstellen (11, 21, 31), **dadurch gekennzeichnet, dass** wenigstens zwei Schnittstellen (11, 21, 31) über ein Verbindungsnetz (7) verbunden sind.

9. Vorrichtung zur Beobachtung und Auswertung nach einem der vorhergehenden Ansprüche, **dadurch gekennzeichnet, dass** jede programmierbare Schaltung (10, 20, 30) des programmierbaren Systems (2) über wenigstens eine Schnittstelle (11, 21, 31) wenigstens einer Speichereinheit (12, 22, 32) zugeordnet ist.

10. Vorrichtung zur Beobachtung und Auswertung nach einem der vorhergehenden Ansprüche, mit wenigstens zwei programmierbaren Schaltungen (10, 20, 30), **dadurch gekennzeichnet, dass** wenigstens zwei programmierbare Schaltungen (10, 20) aus den wenigstens zwei programmierbaren Schaltungen (10, 20, 30) mit ein und derselben Speichereinheit (22) über ein und dieselbe Schnittstelle (21) verbunden sind.

11. Vorrichtung zur Beobachtung und Auswertung nach einem der vorhergehenden Ansprüche, **dadurch gekennzeichnet, dass** das programmierbare System (2) auch wenigstens einen Prozessor (60) umfasst, der mit einer Steuer-Logikeinheit (62) für die Durchführung spezifischer Aufgaben ausgestattet ist.

12. Vorrichtung zur Beobachtung und Auswertung nach einem der vorhergehenden Ansprüche, **dadurch gekennzeichnet, dass** wenigstens eine programmierbare Schaltung (10) wenigstens einen Platzierung-Routing-Prozessor (61) umfasst.

13. Vorrichtung zur Beobachtung und Auswertung nach einem der vorhergehenden Ansprüche, **dadurch gekennzeichnet, dass** wenigstens ein Teil wenigstens einer Speichereinheit (12, 22, 32) für die Speicherung wenigstens eines Stimulus verwendet wird, um wenigstens eine Schaltung aus einer programmierbaren Schaltung (10, 20, 30) und einem Prozessor (60, 61) anzuregen.

14. Vorrichtung zur Beobachtung und Auswertung nach einem der vorhergehenden Ansprüche, **dadurch gekennzeichnet, dass** wenigstens eine Speichereinheit (12, 22, 32) ein flüchtiger Speicher ist.

15. Vorrichtung zur Beobachtung und Auswertung nach einem der vorhergehenden Ansprüche, **dadurch gekennzeichnet, dass** wenigstens eine Verbindung aus den Verbindungen (6, 6', 6", 6"', 13, 14, 15, 16, 17, 18, 23, 24, 25, 26, 27, 28, 33, 34, 35, 36, 37, 38) zwischen den Bauelementen der Vorrichtung eine schnelle Verbindung mit einer Leistung von über 1 Gigabit/Sekunde ist.

16. Vorrichtung zur Beobachtung und Auswertung nach einem der vorhergehenden Ansprüche, **dadurch gekennzeichnet, dass** wenigstens eine Verbindung aus den Verbindungen (6, 6', 6", 6"', 13, 14, 15, 16, 17, 18, 23, 24, 25, 26, 27, 28, 33, 34, 35, 36, 37, 38) zwischen den Bauelementen der Vorrichtung eine drahtlose Verbindung ist.

17. Verfahren zur Beobachtung und Auswertung von internen Signalen eines programmierbaren Systems (2), wobei das Verfahren eine Vorrichtung zur Beobachtung und Auswertung von internen Signalen eines programmierbaren Systems (2) nach einem der vorhergehenden Ansprüche verwendet, wobei die Vorrichtung aus einem programmierbaren System (2) mit wenigstens einer programmierbaren Schaltung (10, 20, 30) und wenigstens einem Host-System (3) besteht, das so ausgebildet ist, dass dieses mit dem programmierbaren System (2) für die Steuerung der Beobachtung und der Auswertung der internen Signale wenigstens einer programmierbaren Schaltung (10, 20, 30) kommuniziert.
